(19) Europäisches Patentamt
European Patent Office
Office européen des brevets

(11) EP 1 655 315 B1

(12) # EUROPEAN PATENT SPECIFICATION

(45) Date of publication and mention of the grant of the patent:
**04.07.2012 Bulletin 2012/27**

(21) Application number: **04771696.4**

(22) Date of filing: **10.08.2004**

(51) Int Cl.:
***C08F 220/18*** *(2006.01)* ***G03F 7/039*** *(2006.01)*
***H01L 21/30*** *(2006.01)*

(86) International application number:
**PCT/JP2004/011735**

(87) International publication number:
**WO 2005/016982 (24.02.2005 Gazette 2005/08)**

(54) **RESIN FOR RESIST, POSITIVE RESIST COMPOSITION, AND METHOD OF FORMING RESIST PATTERN**

HARZ FÜR RESIST, POSITIVRESISTZUSAMMENSETZUNG UND VERFAHREN ZUR HERSTELLUNG EINER RESISTSTRUKTUR

RESINE POUR RESERVE, COMPOSITION DE RESERVE POSITIVE ET PROCEDE DE FORMATION DE MOTIF DE RESERVE

(84) Designated Contracting States:
**DE FR**

(30) Priority: **13.08.2003 JP 2003293000**

(43) Date of publication of application:
**10.05.2006 Bulletin 2006/19**

(73) Proprietor: **TOKYO OHKA KOGYO CO., LTD.**
**Kawasaki-shi, Kanagawa 211-0012 (JP)**

(72) Inventors:
- **HAYASHI, Ryotaro,**
**c/o Tokyo Ohka Kogyo Co., Ltd**
**Kawasaki-shi,**
**Kanagawa 211-0012 (JP)**
- **HADA, Hideo,**
**c/o Tokyo Ohka Kogyo Co., Ltd**
**Kawasaki-shi,**
**Kanagawa 211-0012 (JP)**
- **IWAI, Takeshi,**
**c/o Tokyo Ohka Kogyo Co., Ltd**
**Kawasaki-shi,**
**Kanagawa 211-0012 (JP)**

(74) Representative: **Hart-Davis, Jason et al**
**Cabinet Beau de Loménie**
**158, rue de l'Université**
**75340 Paris Cedex 07 (FR)**

(56) References cited:
**EP-A- 1 452 917**
**EP-A- 1 452 918**
**EP-A- 1 452 919**
**EP-A- 1 596 251**
**EP-A- 1 643 306**
**JP-A- 2003 177 538**
**JP-A- 2003 223 001**
**JP-A- 2003 238 629**
**JP-A- 2003 280 201**
**JP-A- 2004 176 049**
**JP-A- 2004 300 403**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 655 315 B1

## Description

### TECHNICAL FIELD

The present invention relates to a resin for resists that is used in a positive resist composition, a positive resist composition that includes such a resin for resists, and a method of forming a resist pattern that uses such a positive resist composition.

### BACKGROUND ART

In recent years, in the production of semiconductor elements and liquid crystal display elements, advances in lithography techniques have lead to rapid progress in the field of miniaturization. Typically, these miniaturization techniques involve shortening the wavelength of the exposure light source. Conventionally, ultraviolet radiation such as g-lines and i-lines have been used as the exposure light source, but recently, KrF excimer lasers (248 nm) have been introduced.

One example of a known resist material that satisfies the high resolution conditions required to enable reproduction of a pattern of minute dimensions is a chemically amplified resist composition, which includes a base resin that undergoes a change in alkali solubility under the action of acid, and an acid generator that generates acid on exposure. Chemically amplified resist compositions include negative compositions, which contain a cross-linking agent and an alkali-soluble resin as a base resin, and positive compositions, which contain a resin that exhibits increased alkali solubility under the action of acid.

Until now, in KrF excimer laser lithography, polyhydroxystyrenes or derivatives thereof in which the hydroxyl groups have been protected with acid dissociable, dissolution inhibiting groups (protective groups), which exhibit a high level of transparency relative to a KrF excimer laser (248 nm), have typically been used as the base resin of chemically amplified resists.

In recent years, the miniaturization of semiconductor elements has continued to progress, and the development of processes that use ArF excimer lasers (193 nm) is now being vigorously pursued.

However, resins that contain a benzene ring such as the aforementioned polyhydroxystyrenes exhibit poor transparency relative to ArF excimer lasers (193 nm). As a result, if these types of resins are used as the base resin for a resist in a process that uses an ArF excimer laser as the light source, then the resulting resist suffers significant drawbacks, including low resolution.

In contrast, ArF resists with a variety of different compositions are now being proposed. Of these, the most common ArF resist base resins are (meth)acrylic resins, which contain no benzene rings and exhibit a high level of transparency in the region of 193 nm. Because they offer superior levels of dry etching resistance, these (meth)acrylic resins typically include, within the principal chain, structural units derived from a (meth)acrylate ester containing a polycyclic aliphatic hydrocarbon group such as an adamantane skeleton as a protective group (for example, see patent references 1 through 8).

[Patent Reference 1]
Japanese Patent (Granted) Publication No. 2,881,969
[Patent Reference 2]
Japanese Unexamined Patent Application, First Publication No. Hei 5-346668
[Patent Reference 3]
Japanese Unexamined Patent Application, First Publication No. Hei 7-234511
[Patent Reference 4]
Japanese Unexamined Patent Application, First Publication No. Hei 9-73173
[Patent Reference 5]
Japanese Unexamined Patent Application, First Publication No. Hei 9-90637
[Patent Reference 6]
Japanese Unexamined Patent Application, First Publication No. Hei 10-161313
[Patent Reference 7]
Japanese Unexamined Patent Application, First Publication No. Hei 10-319595
[Patent Reference 8]
Japanese Unexamined Patent Application, First Publication No. Hei 11-12326

### DISCLOSURE OF INVENTION

Nowadays, further improvements in the resolution and depth of focus (DOF) of resist materials are being sought

in order to meet the demands of the type of semiconductor element miniaturization described above.

However, investigations conducted by the inventors of the present invention have revealed that resists that use a base resin containing the aforementioned type of polycyclic aliphatic hydrocarbon group as a protective group do not provide entirely satisfactory levels of resolution or depth of focus.

The present invention takes the above circumstances into consideration, with an object of providing a positive resist composition with excellent resolution and depth of focus, as well as a resin for resists that is used in such a positive resist composition, and a method of forming a resist pattern that uses such a positive resist composition.

A first aspect of the present invention for achieving the above object is a resin for resists that contains structural units (a) derived from an (α-lower alkyl)acrylate ester as the principal component, wherein
the structural units (a) include structural units (a1) derived from an (α-lower alkyl)acrylate ester containing an acid dissociable, dissolution inhibiting group, and structural units (a2-1) derived from an (α-lower alkyl)acrylate ester containing a lactone-containing monocyclic group, and
the structural units (a1) include structural units (a1-1) derived from an (α-lower alkyl)acrylate ester and represented by a general formula (a1-1) shown below:

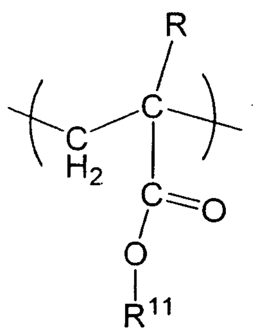

(a1-1)

[wherein, R represents a hydrogen atom or a lower alkyl group, and $R^{11}$ represents an acid dissociable, dissolution inhibiting group that contains a monocyclic aliphatic hydrocarbon group and contains no polycyclic aliphatic hydrocarbon groups].

A second aspect of the present invention for achieving the above object is a resin for resists that contains structural units (a) derived from an (α-lower alkyl)acrylate ester as the principal component, wherein
the structural units (a) include structural units (a1) derived from an (α-lower alkyl)acrylate ester containing an acid dissociable, dissolution inhibiting group, and structural units (a2) derived from an (α-lower alkyl)acrylate ester containing a lactone-containing monocyclic or polycyclic group, and
the structural units (a1) include structural units (a1-1-1) derived from a methacrylate ester and represented by a general formula (a1-1-1) shown below:

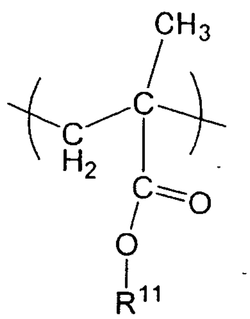

(a1-1-1)

[wherein. $R^{11}$ represents an acid dissociable, dissolution inhibiting group that contains a monocyclic aliphatic hydrocarbon group and contains no polycyclic aliphatic hydrocarbon groups].

A third aspect of the present invention for achieving the above object is a positive resist composition that includes: (A) a resist resin component that exhibits increased alkali solubility under the action of acid, and (B) an acid generator component that generates acid on exposure, wherein
the component (A) includes a resin for resists according to either one of the aforementioned first and second aspects.

A fourth aspect of the present invention for achieving the above object is a method of forming a resist pattern that includes the steps of: forming a positive resist film on top of a substrate using a positive resist composition according to the aforementioned third aspect, conducting a selective exposure treatment of the positive resist film, and performing alkali developing to form the resist pattern.

In the present invention, the term "(α-lower alkyl)acrylate ester" is a generic term that includes both α-lower alkyl acrylate esters and acrylate esters. Furthermore, the term "α-lower alkyl acrylate ester" refers to esters in which the hydrogen atom bonded to the α-carbon atom of the acrylate ester is substituted with a lower alkyl group.

Furthermore, the term "structural unit" refers to a monomer unit that contributes to the formation of a polymer.

In addition, the term "structural unit derived from an (α-lower alkyl)acrylate ester" refers to a structural unit produced by cleavage of the ethylenic double bond of the (α-lower alkyl)acrylate ester.

(Effects of the Invention)

According to a positive resist composition containing a resin for resists of the present invention, a resist pattern with excellent levels of resolution and depth of focus can be formed.

BEST MODE FOR CARRYING OUT THE INVENTION

As follows is a more detailed description of the present invention.

(Resin for Resists)

A resin for resists according to the present invention (hereafter also referred to as the resin (A1)) contains structural units derived from an (α-lower alkyl)acrylate ester as the principal component.

By incorporating the structural units (a) as the principal component, a superior level of transparency is obtained, which enables the resin to be used within a resist for use within processes that use a wavelength of no more than 200 nm, such as an ArF excimer laser.

The above description that refers to the structural unit (a) being the principal component means that of all the structural units that constitute the resin (A1), the structural units (a) account for the highest proportion, and this proportion of the structural units (a) is preferably at least 50 mol%, and even more preferably 80 mol% or higher, and is most preferably 100 mol%. There are no particular restrictions on structural units other than the structural units (a), and any of the units typically used within resins for resists can be used. Examples include structural units derived from either hydroxystyrene or α-methylhydroxystyrene, and structural units derived from styrene or a-methylstyrene.

<Structural Unit (a1)>

The structural units (a) include structural units (a1) derived from an (α-lower alkyl)acrylate ester containing an acid dissociable, dissolution inhibiting group.

The acid dissociable, dissolution inhibiting group within the structural unit (a1) contains an alkali solubility inhibiting group that renders the entire resin (A1) insoluble in alkali prior to exposure, but this alkali solubility inhibiting group then dissociates under the action of acid generated from the component (B) following exposure, causing an increase in the alkali solubility of the entire resin (A1).

[Structural Units (a1-1) and (a1-1-1)]

The structural units (a1) include structural units (a1-1) (the first aspect) or (a1-1-1) (the second aspect) derived from (α-lower alkyl)acrylate esters and represented by the aforementioned general formulas (a1-1) and (a1-1-1) respectively.

In the formula (a1-1), R represents a hydrogen atom or a lower alkyl group, and this lower alkyl group may be either a straight-chain or branched group, but is preferably an alkyl group of 1 to 5 carbon atoms, and is most preferably a methyl group with one carbon atom.

$R^{11}$ represents an acid dissociable, dissolution inhibiting group that contains a monocyclic aliphatic hydrocarbon group (hereafter also referred to as a monocyclic group) and contains no polycyclic aliphatic hydrocarbon groups (hereafter also referred to as polycyclic groups). The number of carbon atoms within the group $R^{11}$ is preferably within a range from 4 to 11, and even more preferably from 5 to 10, and most preferably from 5 to 8.

In the group $R^{11}$, if the carbon atom adjacent to the oxygen atom to which the group $R^{11}$ is bonded is a tertiary carbon atom, then when acid is generated from the component (B) described below, either through heating or light exposure, the action of that acid causes the bond between the tertiary carbon atom and the oxygen atom to break,

causing the dissociation of a portion that includes the monocyclic alicyclic group.

Examples of the group $R^{11}$ include groups in which the polycyclic group such as an adamantyl group within a conventional acid dissociable, dissolution inhibiting group-containing structural unit, such as those shown below in the general formulas (I) and (II), is substituted with a monocyclic group. In other words, the tertiary carbon atom may be either formed as part of the monocyclic group, or may exist between the oxygen atom to which the $R^{11}$ group is bonded and the monocyclic group.

Examples of monocyclic aliphatic hydrocarbon groups include groups in which one hydrogen atom has been removed from a cycloalkane of 4 to 8 carbon atoms such as cyclopentane or cyclohexane. Of these, a group in which one hydrogen atom has been removed from cyclohexane (a cyclohexyl group) is preferred in terms of availability.

Furthermore, examples of polycyclic aliphatic hydrocarbon groups include groups in which one hydrogen atom has been removed from a bicycloalkane, tricycloalkane or tetracycloalkane or the like. Specific examples include groups in which one hydrogen atom has been removed from a polycycloalkane such as adamantane, norbornane, isobornane, tricyclodecane or tetracyclododecane.

Specific examples of the structural units (a1-1) or (a1-1-1) include structural units (a1-2) represented by the general formula (a1-2) shown below, or structural units (a1-2-1) represented by the general formula (a1-2-1) shown below. The ester portion within the structural units (al-2) and (al-2-1), that is, the portion containing the group $R^{12}$, the carbon atom to which the group $R^{12}$ is bonded, and the group X is the acid dissociable, dissolution inhibiting group.

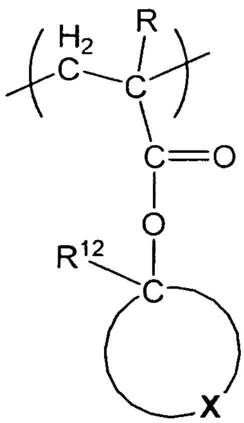

**(a1-2)**

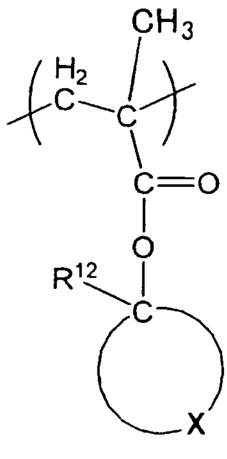

(a1-2-1)

[In the above formula (a1-2), R represents a hydrogen atom or a lower alkyl group. In the formulas (a1-2) and (a1-2-1), $R^{12}$ represents a lower alkyl group, and X represents a group which, in combination with the carbon atom to which the group $R^{12}$ is bonded, forms a monocyclic aliphatic hydrocarbon group.]

In the formula (a1-2), the lower alkyl group of the group R is as defined above.

In the formulas (a1-2) and (a1-2-1), the lower alkyl group of the group $R^{12}$ represents a straight-chain or branched alkyl group, preferably containing from 1 to 8, and even more preferably from 1 to 4, carbon atoms. For industrial reasons, an ethyl group or methyl group is preferred, and an ethyl group is particularly desirable.

Examples of the monocyclic aliphatic hydrocarbon group formed in combination with the carbon atom to which the group $R^{12}$ is bonded are the same as the groups described in relation to the group $R^{11}$ of the structural units (al-1) and (al-1-1), and of these, groups in which one hydrogen atom has been removed from cyclopentane or cyclohexane (a cyclopentyl group or cyclohexyl group respectively) are preferred, and a cyclohexyl group is particularly desirable.
In the resin (A1), in order to maximize the effects of the present invention, the proportion of the structural units (a1) accounted for by the structural units (a1-1) or (a1-1-1) is preferably at least 50 mol%, and even more preferably 80 mol% or greater. A proportion of 100 mol% is the most desirable.

[Structural Units other than the Structural Units (a1-1) or (a1-1-1)]

In the present invention, the structural units (a1) may also include other structural units (a1-3) derived from an ($\alpha$-lower alkyl)acrylate ester containing an acid dissociable, dissolution inhibiting group, that are different from the aforementioned structural units (a1-1) or (a1-1-1).
The acid dissociable, dissolution inhibiting group within these structural units (a1-3) can use any of the groups typically used in conventional chemically amplified resist resins. Because they exhibit superior levels of dry etching resistance, acid dissociable, dissolution inhibiting groups that contain a polycyclic aliphatic hydrocarbon group (a polycyclic group) such as the groups described above are preferred.
This type of polycyclic group can use any of the multitude of groups proposed for the resin component for a resist composition used with an ArF excimer laser. Of these groups, an adamantyl group, norbornyl group, or tetracyclododecanyl group is preferred from an industrial viewpoint.
Specific examples of the structural unit (a1-3) include the groups represented by the general formulas (I), (II), and (III) shown below.

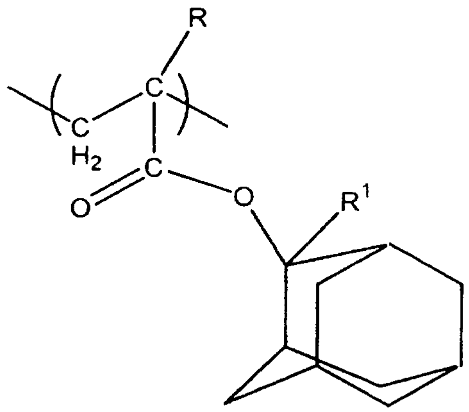

・・・( I )

(wherein, R is as defined above, and $R^1$ represents a lower alkyl group)

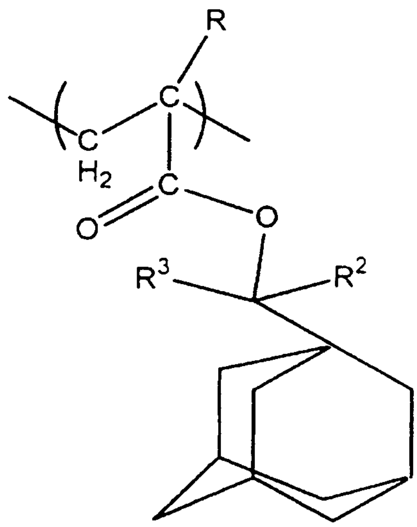

$\cdots$(II)

(wherein, R is as defined above, and $R^2$ and $R^3$ each represent, independently, a lower alkyl group)

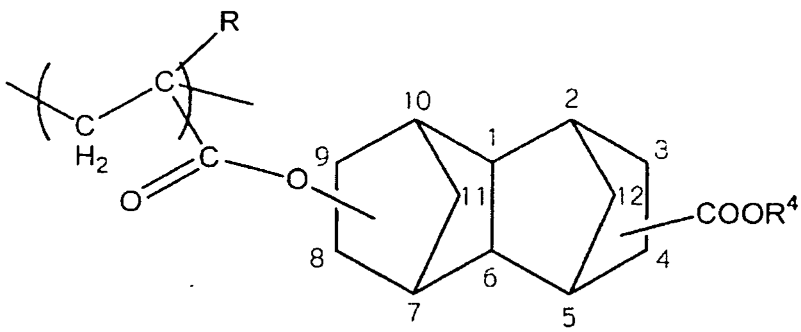

$\cdots$(III)

(wherein, R is as defined above, and $R^4$ represents a tertiary alkyl group).

In the formulas, the group $R^1$ is preferably a straight-chain or branched lower alkyl group of 1 to 5 carbon atoms, and specific examples include a methyl group, ethyl group, propyl group, isopropyl group, n-butyl group, isobutyl group, pentyl group, isopentyl group and neopentyl group. Of these, an alkyl group of at least 2 carbon atoms, and preferably from 2 to 5 carbon atoms is preferred, and in such cases, the acid dissociability tends to increase compared with the case in which $R^1$ is a methyl group. From an industrial viewpoint, a methyl group or ethyl group is preferred.

The groups $R^2$ and $R^3$ each preferably represent, independently, a lower alkyl group of 1 to 5 carbon atoms. These types of groups tend to display a higher acid dissociability than a 2-methyl-2-adamantyl group.

Specifically, the groups $R^2$ and $R^3$ each represent, independently, the same types of straight-chain or branched lower alkyl groups described above for $R^1$. Of these, the case in which $R^2$ and $R^3$ are both methyl groups is preferred from an industrial viewpoint, and specific examples include structural units derived from 2-(1-adamantyl)-2-propyl (meth) acrylate.

The group $R^4$ represents a tertiary alkyl group such as a tert-butyl group or tertamyl group, although the case in which $R^4$ is tert-butyl group is preferred industrially.

Furthermore, the group -$COOR^4$ may be bonded to either position 3 or 4 of the tetracyclododecanyl group shown in the formula, although a mixture of both isomers results, and so the bonding position cannot be further specified. Furthermore, the carboxyl group residue of the (meth)acrylate structural unit may be bonded to either position 8 or 9 of the tetracyclododecanyl group, although similarly, the bonding position cannot be further specified.

In the resin (A1) of the present invention, in order to achieve superior resolution, the structural units (a1) preferably account for 20 to 60 mol%, and even more preferably from 30 to 50 mol%, of the combined total of all the structural units that constitute the resin (A1).

<Structural Units (a2) and (a2-1)>

In the resin (A1), in addition to the structural units (a1), the structural units (a) also include structural units (a2) derived from an (α-lower alkyl)acrylate ester containing a lactone-containing monocyclic or polycyclic group (the second aspect). Alternatively, the structural units (a) may also include, in addition to the structural units (a1), structural units (a2-1) derived from a methacrylate ester containing a lactone-containing monocyclic group (the first aspect). As a result, the adhesion between the resist film and the substrate is improved, and problems such as film peeling are unlikely, even in the case of very fine patterns. Furthermore, the hydrophilicity of the overall resin (A1) increases, improving both the affinity with the developing solution and the alkali solubility of the exposed portions, which contributes to an improvement in the resolution.

Examples of the structural units (a2) include structural units in which a monocyclic group formed from a lactone ring or an aliphatic polycyclic group that includes a lactone ring is bonded to the ester side chain section of an (α-lower alkyl)acrylate ester. The term "lactone ring" refers to a single ring containing a -O-C(O)-structure, and this ring is counted as the first ring. Accordingly, the case in which the only ring structure is the lactone ring is referred to as a monocyclic group, and groups containing other ring structures are described as polycyclic groups regardless of the structure of the other rings.

Specific examples of the lactone-containing ring in the structural units (a2) include monocyclic groups in which one hydrogen atom has been removed from γ-butyrolactone, and polycyclic groups in which one hydrogen atom has been removed from a lactone-containing polycycloalkane. Alkyl groups of 1 to 5 carbon atoms may also be bonded to the lactone-containing monocyclic or polycyclic group.

Specifically, the structural units (a2) are preferably units represented by the structural formulas (IV) to (VII) shown below.

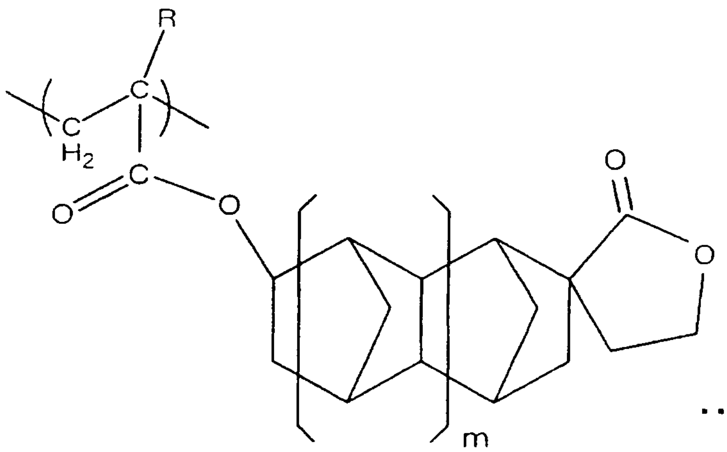

···(IV)

(wherein. R is as defined above, and m represents either 0 or 1)

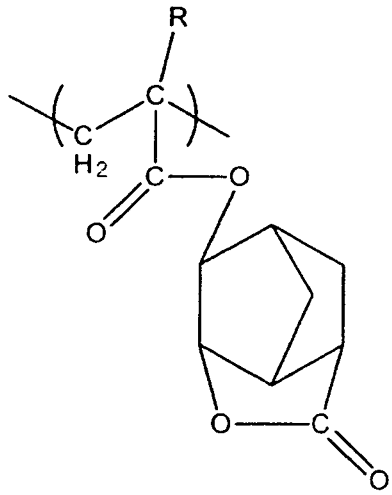

···(V)

(wherein, R is as defined above)

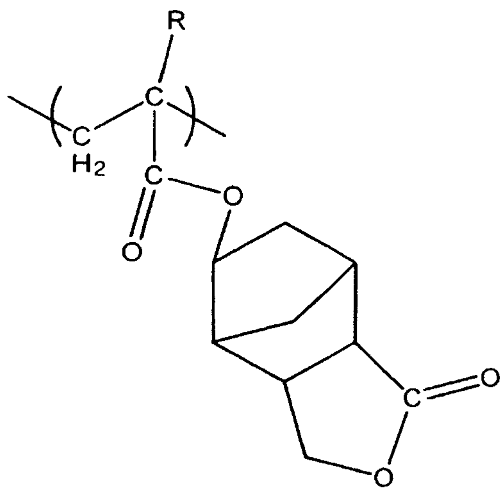

···(VI)

(wherein, R is as defined above)

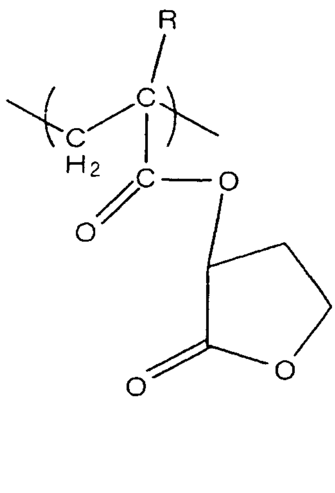

···(VII)

(wherein, R is as defined above)

Examples of the structural units (a2-1) include structural units in which a monocyclic group formed from a lactone ring is bonded to the ester side chain section of an (α-lower alkyl)acrylate ester. Specific examples of the lactone-containing ring in the structural units (a2-1) include monocyclic groups in which one hydrogen atom has been removed from γ-butyrolactone. Alkyl groups of 1 to 5 carbon atoms may also be bonded to this lactone-containing monocyclic group.

Specifically, the structural units (a2-1) are preferably units represented by the aforementioned structural formula (VII).

The structural units (a2) or (a2-1) preferably account for 20 to 60 mol%, and even more preferably from 20 to 50 mol%, of the combined total of all the structural units that constitute the resin (A1).

<Structural Unit (a3)>

In the resin (A1), in addition to the structural units (a1) and the structural units (a2) or (a2-1), the structural units (a) preferably also include structural units (a3) derived from an (α-lower alkyl)acrylate ester that contains a polar group-containing aliphatic hydrocarbon group. Including such structural units (a3) increases the hydrophilicity of the overall resin (A1), thereby improving both the affinity with the developing solution and the alkali solubility of the exposed portions, which contributes to an improvement in the resolution.

Examples of the polar group include a hydroxyl group or cyano group, although a hydroxyl group is particularly preferred.

Examples of the aliphatic hydrocarbon group include straight-chain or branched hydrocarbon groups (alkylene groups) of 1 to 10 carbon atoms, and polycyclic aliphatic hydrocarbon groups (polycyclic groups). These polycyclic groups can be selected appropriately from the same multitude of groups described above in relation to the structural units (a1).

In those cases where the hydrocarbon group within the polar group-containing aliphatic hydrocarbon group is a straight-chain or branched hydrocarbon group of 1 to 10 carbon atoms, the structural units (a3) are preferably units derived from the hydroxyethyl ester of an (α-lower alkyl)acrylic acid, whereas in those cases where the hydrocarbon group is a polycyclic group, structural units represented by a general formula (VIII) shown below are preferred.

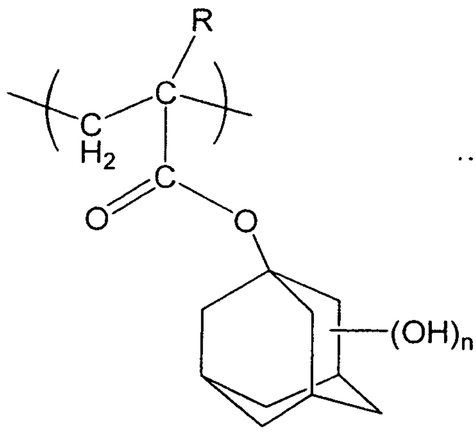

···(VIII)

(wherein, R is as defined above, and n represents an integer from 1 to 3)

Of these, the structural unit in which n is 1, and the hydroxyl group is bonded to position 3 of the adamantyl group is preferred.

The structural units (a3) preferably account for 10 to 50 mol%, and even more preferably from 20 to 40 mol%, of the combined total of all the structural units that constitute the resin (A1).

<Structural Unit (a4)>

The resin (A 1) may also include other structural units (a4) derived from an (α-lower alkyl)acrylate ester that contains a polycyclic aliphatic hydrocarbon group, which differ from both the structural units (a2) and (a3).

Here, the description "differ from both the structural units (a2) and (a3)" means that these units do not duplicate the structural units (a2) and (a3), although examples of the polycyclic aliphatic hydrocarbon group (the polycyclic group) include the same multitude of polycyclic groups described in relation to the structural units (a2) and (a3).

In terms of industrial availability and the like, one or more groups selected from amongst tricyclodecanyl groups,

adamantyl groups, tetracyclododecanyl groups, and isobornyl groups are preferred.

Specific examples of the structural units (a4) include units of the structures (IX) to (XI) shown below.

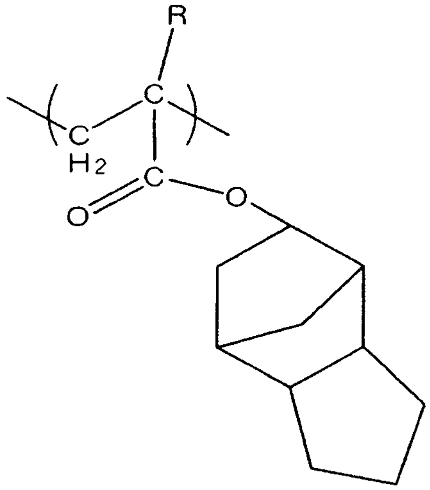

···(IX)

(wherein, R is as defined above)

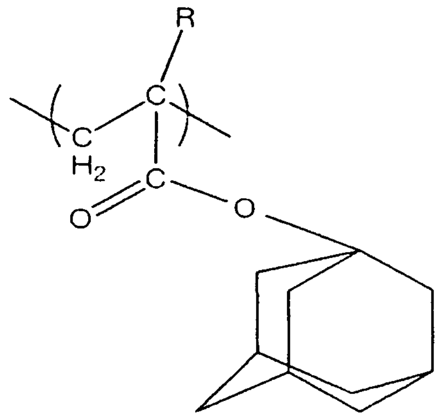

···(X)

(wherein, R is as defined above)

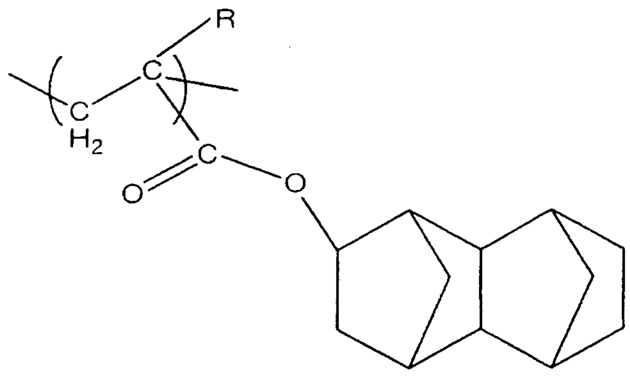

···(XI)

(wherein, R is as defined above)

The structural units (a4) preferably account for 1 to 25 mol%, and even more preferably from 10 to 20 mol%, of the combined total of all the structural units that constitute the resin (A1).

<Structural Unit (a5)>

The resin (A1) may also include structural units (a5) that are different from any of the structural units (a1) through (a4).

There are no particular restrictions on the structural units (a5), provided they are different structural units that cannot be classified as any of the above structural units (a1) through (a4), and any of the multitude of materials conventionally used within resist resins for use with ArF excimer lasers or KrF excimer lasers (but preferably ArF excimer lasers) can be used.

Although there are no particular restrictions on the weight average molecular weight (the polystyrene equivalent value determined by gel permeation chromatography) of the resin (A1), the value is preferably within a range from 5,000 to 30,000, and even more preferably from 6,000 to 20,000.

The resin (A 1) can be produced by a conventional radical polymerization or the like of the monomers corresponding with each of the aforementioned structural units, using a radical polymerization initiator such as azobisisobutyronitrile (AIBN).

(Positive Resist Composition)

A positive resist composition of the present invention includes (A) a resist resin component (hereafter referred to as the component (A)) that exhibits increased alkali solubility under the action of acid, and (B) an acid generator component (hereafter referred to as the component (B)) that generates acid on exposure.

<Component (A)>

A positive resist composition of the present invention includes the aforementioned resin for resists according to the present invention (the resin (A1)) as the component (A).

The quantity of the resin (A1) within the component (A) is preferably at least 50% by weight, and even more preferably within a range from 80 to 100% by weight, and is most preferably 100% by weight. By incorporating at least 50% by weight of the resin (A1), a superior resolution improvement effect can be obtained.

In the present invention, in addition to the resin (A 1), the component (A) may also use any of the multitude of resins typically used as resist resins.

Examples of such resins include resins that contain structural units (a1-3) different from the structural units (a1-1) or (a1-1-1)'of the aforementioned resin (A1), and may also include optional resins such as the aforementioned structural units (a2) through (a5).

<Component (B)>

As the component (B), a compound appropriately selected from known materials used as acid generators in conventional chemically amplified resists can be used. Examples of these acid generators are numerous, and include onium salt-based acid generators such as iodonium salts and sulfonium salts, oxime sulfonate-based acid generators, diazomethane-based acid generators such as bisalkyl or bisaryl sulfonyl diazomethanes and poly(bis-sulfonyl)diazomethanes, nitrobenzyl sulfonate-based acid generators, iminosulfonate-based acid generators, and disulfone-based acid generators.

Of these acid generators, onium salts containing a fluorinated alkylsulfonate ion as the anion are preferred. Specific examples of suitable onium salt-based acid generators include diphenyliodonium trifluoromethanesulfonate or nonafluorobutanesulfonate, bis(4-tert-butylphenyl)iodonium trifluoromethanesulfonate or nonafluorobutanesulfonate, triphenylsulfonium trifluoromethanesulfonate, heptafluoropropanesulfonate or nonafluorobutanesulfonate, tri(4-methylphenyl)sulfonium trifluoromethanesulfonate, heptafluoropropanesulfonate or nonafluorobutanesulfonate, dimethyl(4-hydroxynaphthyl)sulfonium trifluoromethanesulfonate, heptafluoropropanesulfonate or nonafluorobutanesulfonate, monophenyldimethylsulfonium trifluoromethanesulfonate, heptafluoropropanesulfonate or nonafluorobutanesulfonate, diphenylmonomethylsulfonium trifluoromethanesulfonate, heptafluoropropanesulfonate or nonafluorobutanesulfonate, (4-methylphenyl)diphenylsulfonium trifluoromethanesulfonate, heptafluoropropanesulfonate or nonafluorobutanesulfonate, (4-methoxyphenyl)diphenylsulfonium trifluoromethanesulfonate, heptafluoropropanesulfonate or nonafluorobutanesulfonate, and tri(4-tert-butyl)phenylsulfonium trifluoromethanesulfonate, heptafluoropropanesulfonate or nonafluorobutanesulfonate.

Of these, sulfonium salts are preferred, and nonafluorobutanesulfonate salts are particularly desirable. As the component (B), either a single acid generator can be used alone, or a combination of two or more different compounds can be used.
The quantity used of the component (B) is typically within a range from 0.5 to 30 parts by weight, and preferably from 1 to 10 parts by weight, per 100 parts by weight of the component (A). At quantities less than 0.5 parts by weight, there is a danger that pattern formation may not proceed satisfactorily, whereas if the quantity exceeds 30 parts by weight, achieving a uniform solution can be difficult, which increases the danger of a deterioration in the storage stability.

<Component (C)>

A positive resist composition of the present invention can be produced by dissolving the materials in an organic solvent (C) (hereafter referred to as the component (C)).
The component (C) may be any solvent capable of dissolving the various components to generate a uniform solution, and one or more solvents selected from known materials used as the solvents for conventional chemically amplified resists can be used.
Specific examples of the solvent include γ-butyrolactone, ketones such as acetone, methyl ethyl ketone, cyclohexanone, methyl isoamyl ketone and 2-heptanone; polyhydric alcohols and derivatives thereof such as ethylene glycol, ethylene glycol monoacetate, diethylene glycol, diethylene glycol monoacetate, propylene glycol, propylene glycol monoacetate, dipropylene glycol, or the monomethyl ether, monoethyl ether, monopropyl ether, monobutyl ether or monophenyl ether of dipropylene glycol monoacetate; cyclic ethers such as dioxane; and esters such as methyl lactate, ethyl lactate (EL), methyl acetate, ethyl acetate, butyl acetate, methyl pyruvate, ethyl pyruvate, methyl methoxypropionate, and ethyl ethoxypropionate. These organic solvents can be used alone, or as a mixed solvent of two or more different solvents.
Furthermore, mixed solvents of propylene glycol monomethyl ether acetate (PGMEA) and a polar solvent are preferred. The blend ratio (weight ratio) in such mixed solvents can be set in accordance with factors such as the co-solubility of the PGMEA and the polar solvent, but is preferably within a range from 9:1 to 1:9, and even more preferably from 8:2 to 2:8.
More specifically, in those cases where EL is added as the polar solvent, the weight ratio PGMEA:EL is preferably within a range from 8:2 to 2:8, and even more preferably from 7:3 to 3:7. Furthermore, as the component (C), mixed solvents containing at least one of PGMEA and EL, together with γ-butyrolactone, are also preferred. In such cases, the weight ratio of the former and latter components in the mixed solvent is preferably within a range from 70:30 to 95:5. Furthermore, propylene glycol monomethyl ether (PGME) is also preferred as the component (C).
There are no particular restrictions on the quantity used of the component (C), although the quantity should provide a concentration that enables favorable application of the solution to a substrate or the like, and is typically set so that the solid fraction concentration within the resist composition falls within a range from 2 to 20% by weight, and even more preferably from 5 to 15% by weight.

<Component (D)>

In a positive resist composition of the present invention, in order to improve properties such as the resist pattern shape and the post exposure stability of the latent image formed by the pattern-wise exposure of the resist layer, a nitrogen-containing organic compound (D) (hereafter referred to as the component (D)) can also be added as an optional component.
A multitude of these components (D) have already been proposed, and any of these known compounds can be used, although an amine, and particularly a secondary lower aliphatic amine or tertiary lower aliphatic amine, is preferred.
Here, a lower aliphatic amine refers to an alkyl or alkyl alcohol amine of no more than 5 carbon atoms, and examples of these secondary and tertiary amines include trimethylamine, diethylamine, triethylamine, di-n-propylamine, tri-n-propylamine, tripentylamine, diethanolamine, and triethanolamine, and tertiary alkanolamines such as triethanolamine and triisopropanolamine are particularly preferred.
These compounds may be used alone, or in combinations of two or more different compounds.
This component (D) is typically added in a quantity within a range from 0.01 to 2.0 parts by weight per 100 parts by weight of the component (A).

<Component (E)>

Furthermore, in order to prevent any deterioration in sensitivity caused by the addition of the aforementioned component (D), and improve the resist pattern shape and the post exposure stability of the latent image formed by the

pattern-wise exposure of the resist layer, an organic carboxylic acid, or a phosphorus oxo acid or derivative thereof (E) (hereafter referred to as the component (E)) can also be added as another optional component. The component (D) and the component (E) can be used in combination, or either one may also be used alone.

Examples of suitable organic carboxylic acids include malonic acid, citric acid, malic acid, succinic acid, benzoic acid, and salicylic acid.

Examples of suitable phosphorus oxo acids or derivatives thereof include phosphoric acid or derivatives thereof such as esters, including phosphoric acid, di-n-butyl phosphate and diphenyl phosphate; phosphonic acid or derivatives thereof such as esters, including phosphonic acid, dimethyl phosphonate, di-n-butyl phosphonate, phenylphosphonic acid, diphenyl phosphonate, and dibenzyl phosphonate; and phosphinic acid or derivatives thereof such as esters, including phosphinic acid and phenylphosphinic acid, and of these, phosphonic acid is particularly preferred.

This component (E) is typically used in a quantity within a range from 0.01 to 5.0 parts by weight per 100 parts by weight of the component (A).

<Other Optional Components>

Other miscible additives can also be added to a positive resist composition of the present invention according to need, including additive resins for improving the properties of the resist film, surfactants for improving the ease of application, dissolution inhibitors, plasticizers, stabilizers, colorants and halation prevention agents.

A positive resist composition of the present invention exhibits excellent resolution. Furthermore, by using a positive resist composition of the present invention, a resist pattern with favorable levels of line edge roughness (LER) can be formed. Furthermore, the depth of focus of trench patterns is also excellent.

The reasons for these observations are not entirely clear, but are thought to be as follows. In processes that use ArF excimer lasers, in order to ensure an adequate level of dry etching resistance, resins containing acid dissociable, dissolution inhibiting groups (protective groups) that include an aliphatic polycyclic group such as an adamantyl group have conventionally been used as the resist resin. However, these types of protective groups are very bulky, and it is thought that because the boiling point of the dissociated material generated following dissociation of these protective groups is high, this dissociated material is prone to being retained within the resist film. It is surmised that this type of dissociated material then functions as a plasticizer within the resist film, softening the resist film, and thereby extending the diffusion range of the acid generated within the resist film and hindering any improvement in the resolution.

In contrast, a resin for resists according to the present invention contains the aforementioned structural units (a1-1), or in other words, uses, as a protective group, an acid dissociable, dissolution inhibiting group that contains a monocyclic aliphatic hydrocarbon group and contains no polycyclic aliphatic hydrocarbon groups. As a result, it is thought that this resin for resists is able to retain a certain degree of dry etching resistance, while the dissociated material is less likely to remain within the resist film, meaning the diffusion of the acid can be more reliably controlled, leading to an improvement in the resolution.

Furthermore, it is thought that because the diffusion of the acid can be more reliably controlled, the shape of the side walls of the formed resist pattern will also improve, resulting in an improvement in LER.

In addition, a positive resist composition of the present invention also exhibits a favorable MEF (mask error factor). The MEF is a parameter that indicates how faithfully mask patterns of differing line width or hole diameter can be reproduced using the same exposure dose, and is determined using the formula shown below. The MEF is preferably as close as possible to 1.

$$MEF = | CD_x - CD_y | / | MD_x - MD_y |$$

In this formula, $MD_x$ and MDy represent the sizes (nm) of two different mask patterns, and $CD_x$ and CDy represent the respective sizes (nm) of the resist patterns formed using each of the mask patterns.

(Method of Forming Resist Pattern)

A method of forming a resist pattern according to the present invention can be conducted, for example, in the manner described below.

Namely, a positive resist composition described above is first applied to a substrate such as a silicon wafer using a spinner or the like, and a prebake is then conducted under temperature conditions of 80 to 150°C, for a period of 40 to 120 seconds, and preferably for 60 to 90 seconds. Following selective exposure of the thus obtained film with an ArF exposure apparatus or the like, by irradiating ArF excimer laser light through a desired mask pattern, PEB (post exposure baking) is conducted under temperature conditions of 80 to 150°C, for a period of 40 to 120 seconds, and

preferably for 60 to 90 seconds. Subsequently, developing is conducted using an alkali developing solution such as a 0.1 to 10% by weight aqueous solution of tetramethylammonium hydroxide. In this manner, a resist pattern that is faithful to the mask pattern can be obtained.

An organic or inorganic anti-reflective film may also be provided between the substrate and the applied layer of the resist composition.

There are no particular restrictions on the wavelength used for the exposure, and an ArF excimer laser, KrF excimer laser, $F_2$ excimer laser, or other radiation such as EUV (extreme ultraviolet), VUV (vacuum ultraviolet), EB (electron beam), X-ray or soft X-ray radiation can be used. A positive resist composition according to the present invention is particularly effective for use with an ArF excimer laser.

EXAMPLES

As follows is a more detailed description of the present invention using a series of examples.

(a11): 1-ethyl-1-cyclohexyl methacrylate (the monomer corresponding with the structural unit of the general formula (a1-2) wherein R is a methyl group, $R^{12}$ is an ethyl group, and the ring formed by X in combination with the carbon atom to which the group $R^{12}$ is bonded is a cyclohexyl group).

(a12): 1-ethyl-1-cyclopentyl methacrylate (the monomer corresponding with the structural unit of the general formula (a1-2) wherein R is a methyl group, $R^{12}$ is an ethyl group, and the ring formed by X in combination with the carbon atom to which the group $R^{12}$ is bonded is a cyclopentyl group).

(a13): 2-methyl-2-adamantyl methacrylate (the monomer corresponding with the structural unit of the general formula (I) wherein R is a methyl group, and $R^1$ is a methyl group).

(a14): 2-ethyl-2-adamantyl methacrylate (the monomer corresponding with the structural unit of the general formula (I) wherein R is a methyl group, and $R^1$ is an ethyl group).

(a21): γ-butyrolactone methacrylate (the monomer corresponding with the structural unit of the general formula (VII) wherein R is a methyl group).

(a22): norbornane lactone acrylate (the monomer corresponding with the structural unit of the general formula (VI) wherein R is a hydrogen atom).

(a31): 3-hydroxy-1-adamantyl methacrylate (the monomer corresponding with the structural unit of the general formula (VIII) wherein R is a methyl group, n is 1, and the hydroxyl group is bonded to position 3 of the adamantyl group).

(a32): 3-hydroxy-1-adamantyl acrylate (the monomer corresponding with the structural unit of the general formula (VIII) wherein R is a hydrogen atom, n is 1, and the hydroxyl group is bonded to position 3 of the adamantyl group).

Synthesis Example 1

0.25 mols of a mixture containing 0.1 mols of the above monomer (a11), 0.1 mols of the monomer (a21) and 0.05 mols of the monomer (a31) was dissolved in 500 ml of methyl ethyl ketone (MEK), and 0.01 mols of AIBN was then added to the solution and dissolved. The resulting solution was heated to 65 to 70°C, and this temperature was maintained for 3 hours. Subsequently, the reaction solution was poured into 3 L of vigorously stirred isopropanol, and the precipitated solid was isolated by filtration. The thus obtained solid product was dissolved in 300 ml of MEK, poured into 3 L of vigorously stirred methanol, and once again the precipitated solid was isolated by filtration and then dried, yielding a resist resin (X1).

Analysis of the resist resin (X1) revealed a weight average molecular weight of 10,000, and a polydispersity (Mw/Mn) of 1.7. Furthermore, the results of carbon 13 ($^{13}C$) NMR measurements confirmed that the ratio between the structural units derived from the aforementioned monomers (a11), (a21), and (a31) was 40:40:20 (molar ratio). These structural units are shown below in the formulas (XII).

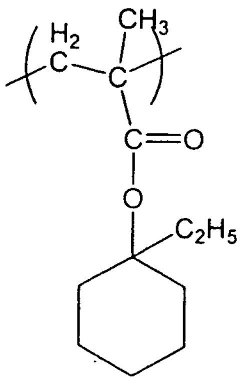 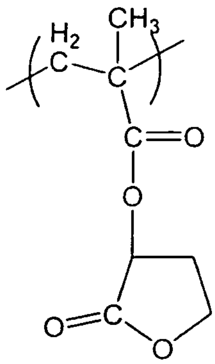 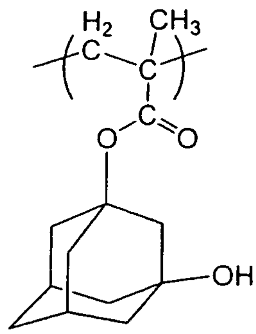

(XII)

Synthesis Example 2

0.25 mols of a mixture containing 0.1 mols of the above monomer (a12), 0.1 mols of the monomer (a21) and 0.05 mols of the monomer (a31) was dissolved in 500 ml of methyl ethyl ketone (MEK), and 0.01 mols of AIBN was then added to the solution and dissolved. The resulting solution was heated to 65 to 70°C, and this temperature was maintained for 3 hours. Subsequently, the reaction solution was poured into 3 L of vigorously stirred isopropanol, and the precipitated solid was isolated by filtration. The thus obtained solid product was dissolved in 300 ml of MEK, poured into 3 L of vigorously stirred methanol, and once again the precipitated solid was isolated by filtration and then dried, yielding a resist resin (X2).

Analysis of the resist resin (X2) revealed a weight average molecular weight of 10,000, and a polydispersity (Mw/Mn) of 1.6. Furthermore, the results of carbon 13 ($^{13}C$) NMR measurements confirmed that the ratio between the structural units derived from the aforementioned monomers (a12), (a21), and (a31) was 40:40:20 (molar ratio). These structural units are shown below in the formulas (XIII).

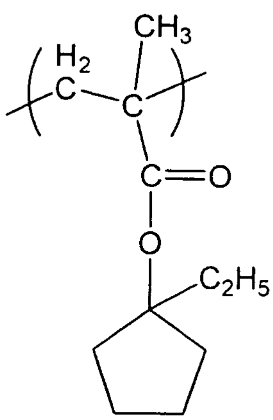 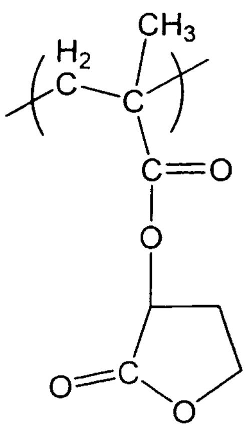 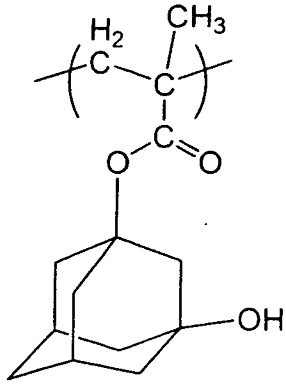

(XIII)

Synthesis Example 3

0.25 mols of a mixture containing 0.1 mols of the above monomer (a11), 0.1 mols of the monomer (a22) and 0.05 mols of the monomer (a32) was dissolved in 500 ml of methyl ethyl ketone (MEK), and 0.01 mols of AIBN was then added to the solution and dissolved. The resulting solution was heated to 65 to 70°C, and this temperature was maintained for 3 hours. Subsequently, the reaction solution was poured into 3 L of vigorously stirred isopropanol, and the precipitated

solid was isolated by filtration. The thus obtained solid product was dissolved in 300 ml of MEK, poured into 3 L of vigorously stirred methanol, and once again the precipitated solid was isolated by filtration and then dried, yielding a resist resin (X3).

Analysis of the resist resin (X3) revealed a weight average molecular weight of 10,000, and a polydispersity (Mw/Mn) of 1.7. Furthermore, the results of carbon 13 ($^{13}C$) NMR measurements confirmed that the ratio between the structural units derived from the aforementioned monomers (a11), (a22), and (a32) was 40:40:20 (molar ratio). These structural units are shown below in the formulas (XIV).

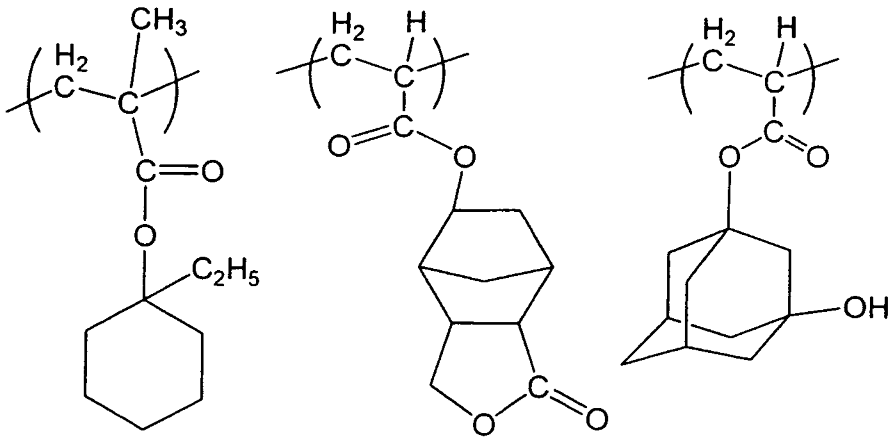

(XIV)

Comparative Synthesis Example 1

0.25 mols of a mixture containing 0.1 mols of the above monomer (a13), 0.1 mols of the monomer (a21) and 0.05 mols of the monomer (a31) was dissolved in 500 ml of methyl ethyl ketone (MEK), and 0.01 mols of AIBN was then added to the solution and dissolved. The resulting solution was heated to 65 to 70°C, and this temperature was maintained for 3 hours. Subsequently, the reaction solution was poured into 3 L of vigorously stirred isopropanol, and the precipitated solid was isolated by filtration. The thus obtained solid product was dissolved in 300 ml of MEK, poured into 3 L of vigorously stirred methanol, and once again the precipitated solid was isolated by filtration and then dried, yielding a resist resin (Y1).

Analysis of the resist resin (Y1) revealed a weight average molecular weight of 10,000. Furthermore, the results of carbon 13 ($^{13}C$) NMR measurements confirmed that the ratio between the structural units derived from the aforementioned monomers (a13), (a21), and (a31) was 40:40:20 (molar ratio). These structural units are shown below in the formulas (XV).

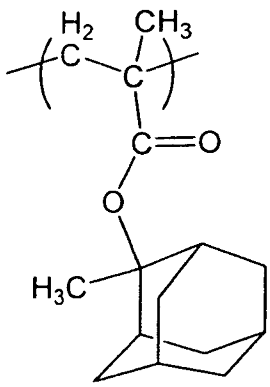 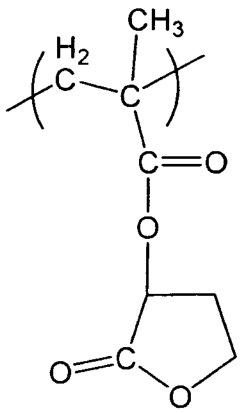 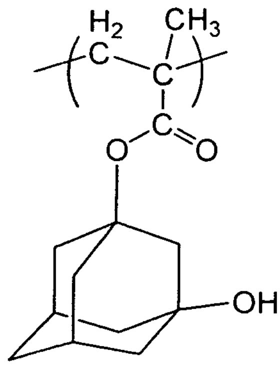

(XV)

Comparative Synthesis Example 2

0.25 mols of a mixture containing 0.1 mols of the above monomer (a14), 0.1 mols of the monomer (a22) and 0.05 mols of the monomer (a32) was dissolved in 500 ml of methyl ethyl ketone (MEK), and 0.01 mols of AIBN was then added to the solution and dissolved. The resulting solution was heated to 65 to 70°C, and this temperature was maintained for 3 hours. Subsequently, the reaction solution was poured into 3 L of vigorously stirred isopropanol, and the precipitated solid was isolated by filtration. The thus obtained solid product was dissolved in 300 ml of MEK, poured into 3 L of vigorously stirred methanol, and once again the precipitated solid was isolated by filtration and then dried, yielding a resist resin (Y2).

Analysis of the resist resin (Y2) revealed a weight average molecular weight of 10,000. Furthermore, the results of carbon 13 ($^{13}C$) NMR measurements confirmed that the ratio between the structural units derived from the aforementioned monomers (a14), (a22), and (a32) was 40:40:20 (molar ratio). These structural units are shown below in the formulas (XVI).

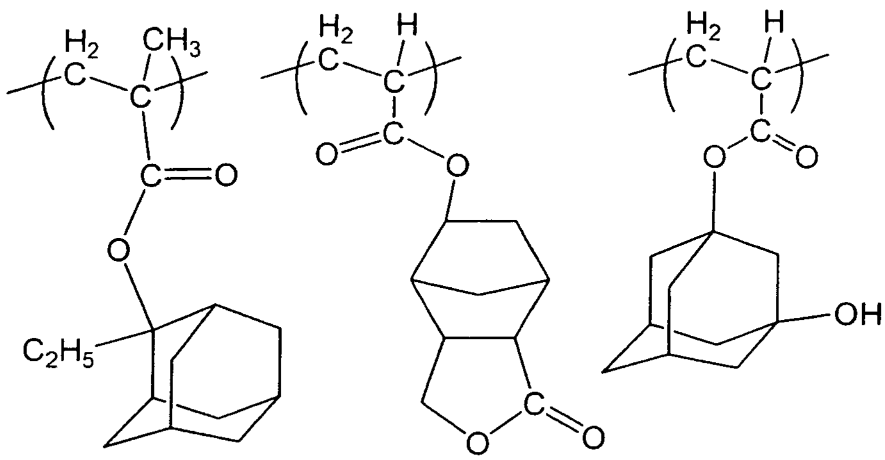

The above results are summarized below in Table 1.

Table 1

| | (a11) | (a12) | (a13) | (a14) | (a21) | (a22) | (a31) | (a32) | Molecular weight |
|---|---|---|---|---|---|---|---|---|---|
| Synthesis example 1 (X1) | 40 | | | | 40 | | 20 | | 10,000 |
| Synthesis example 2 (X2) | | 40 | | | 40 | | 20 | | 10,000 |
| Synthesis example 3 (X3) | | 40 | | | | 40 | | 20 | 10,000 |
| Comparative Synthesis example 1 (Y1) | | | 40 | | 40 | | 20 | | 10,000 |
| Comparative Synthesis example 2 (Y2) | | | | 40 | | 40 | | 20 | 10,000 |

Example 1

A mixture of 100 parts by weight of the resin (X1) obtained in the synthesis example 1, 2.0 parts by weight of diphenyl-3-methylphenylsulfonium nonafluorobutanesulfonate (hereafter abbreviated as PAG1) and 0.8 parts by weight of tri(tert-butylphenyl)sulfonium trifluoromethanesulfonate (hereafter abbreviated as PAG2) as the component (B), and 0.25 parts by weight of triethanolamine (hereafter abbreviated as AMINE1) as the component (D) was dissolved in 25 parts by weight of γ-butyrolactone and 900 parts by weight of a mixed solvent containing propylene glycol monomethyl ether acetate (PGMEA) and ethyl lactate (EL) (weight ratio 8:2), thereby yielding a positive resist composition.

Subsequently, an organic anti-reflective film composition ARC-29A (product name, manufactured by Brewer Science Ltd.) was applied to the surface of a silicon wafer using a spinner, and the composition was then baked and dried on a hotplate at 215°C for 60 seconds, thereby forming an organic anti-reflective film with a film thickness of 77 nm. The above positive resist composition was then applied to the surface of this organic anti-reflective film using a spinner, and was then prebaked and dried on a hotplate at 115°C for 90 seconds, thereby forming a resist layer with a film thickness of 300 nm.

This layer was then selectively irradiated with an ArF excimer laser (193 nm) through a mask pattern, using an ArF exposure apparatus NSR-S302 (manufactured by Nikon Corporation; NA (numerical aperture) = 0.60, 2/3 annular illumination).

The resist was then subjected to PEB treatment at 115°C for 90 seconds, subsequently subjected to puddle development for 60 seconds at 23°C in a 2.38% by weight aqueous solution of tetramethylammonium hydroxide, and was then washed for 20 seconds with water, and dried, thus forming a resist pattern.

As a result, the resolution limit for a trench pattern obtained using the positive resist composition of the example 1, using the same exposure dose as that required to transfer a 130 nm mask at 130 nm, was 110 nm.

Furthermore, L&S patterns were also formed in the same manner as above using mask patterns with L&S spaces of 120 nm and 200 nm, and the formula shown below was then used to determine the MEF (mask error factor).

$$MEF = | CD_{200} - CD_{120} | / | MD_{200} - MD_{120} |$$

In this formula, $CD_{200}$ and $CD_{120}$ represent the respective resist pattern widths (nm) of the L&S patterns formed using the 200 nm and 120 nm mask patterns, and $MD_{200}$ and $MD_{120}$ represent the respective mask pattern widths (nm), meaning $MD_{200}$ = 200 and $MD_{120}$ = 120. The result revealed a MEF of 0.96.

Furthermore, the 3σ value, which is an indicator of the LER, was also determined for the 120 nm line and space (L&S) pattern formed above. The result indicated a 3σ value for the pattern of 4.3 nm.

The 3σ value is determined by measuring the resist pattern width of a sample at 32 positions using a measuring SEM (S-9220, a product name, manufactured by Hitachi, Ltd.), and calculating the value of 3 times the standard deviation (3σ) from these measurement results. The smaller this 3σ value is, the lower the level of roughness, indicating a resist pattern with a uniform width.

Furthermore, the sensitivity was 31 mJ/cm$^2$, and the depth of focus for a trench with a 130 nm space portion was 600 nm.

Comparative Example 1

With the exception of replacing the resin (X1) from the example 1 with the resin (Y1) obtained in the comparative synthesis example 1, a positive resist composition was prepared in the same manner as the example 1.
Subsequently, with the exception of changing both the prebake temperature and the PEB temperature to 130°C, a resist pattern was formed, and the properties of this pattern were evaluated, in the same manner as the example 1.
The results revealed a resolution limit for the obtained trench pattern of 120 nm, a MEF of 0.66, and a 3σ value of 6.5 nm. Furthermore, the sensitivity was 29 $mJ/cm^2$, and the depth of focus for the trench pattern with a 130 nm space portion was 400 nm.
From the above results is clear that the positive resist composition of the example 1, containing the resin (X1) obtained in the synthesis example 1, exhibited superior resolution. Furthermore, the MEF was close to 1, and the resist pattern obtained using the positive resist composition was very favorable, with minimal LER. The depth of focus was also excellent.

Examples 2 and 3, Comparative Example 2

Positive resist compositions were prepared using the compositions shown below in Table 2, resist patterns were then formed using the mounting conditions shown below in Table 3, and the results for these resist patterns are summarized in Table 4. Unless stated otherwise, the values within parentheses in the tables refer to parts by weight.

Table 2

| | (A) | (B) | (D) | (C) | Other |
|---|---|---|---|---|---|
| Examples 1 | X1 (100) | PAG1 (2.0) PAG2 (0.8) | AMINE1 (0.25) | PGMEA/EL = 8/2 (900) | γ-butyrolactone (25) |
| Example 2 | X2 (100) | PAG1 (2.0) PAG2 (0.8) | AMINE1 (0.25) | PGMEA/EL=8/2 (900) | γ-butyrolactone (25) |
| Example 3 | X3 (100) | PAG3 (2.0) | AMINE1 (0.1) | PGMEA/EL = 8/2 (1200) | - |
| Comparative example 1 | Y1 (100) | PAG1 (2.0) PAG2 (0.8) | AMINE1 (0.25) | PGMEA/EL = 8/2 (900) | γ-butyrolactone (25) |
| Comparative example 2 | Y2 (100) | PAG3 2.0 | AMINE1 (0.1) | PGMEA/EL = 8/2 (1200) | - |

Table 3

| | Substrate | Anti-reflective film | Resist film thickness | PAB | PEB | Light source |
|---|---|---|---|---|---|---|
| Example 1 | 8-inch Si | ARC29A (77 nm) | 300 nm | 115°C 90 seconds | 115°C 90 seconds | ArF |
| Example 2 | 8-inch Si | ARC29A (77 nm) | 300 nm | 115°C 90 seconds | 115°C 90 seconds | ArF |
| Example 3 | 8-inch Si | ARC29A (77 nm) | 200 nm | 115°C 90 seconds | 105°C 90 seconds | ArF |
| Comparative example 1 | 8-inch Si | ARC29A (77 nm) | 300 nm | 130°C 90 seconds | 130°C 90 seconds | ArF |
| Comparative example 2 | 8-inch Si | ARC29A (77 nm) | 200 nm | 120°C 90 seconds | 110°C 90 seconds | ArF |

Exposure apparatus for the examples 1 and 2 and the comparative example 1: Nikon NSR-S302 (NA = 0.6, 2/3 annular illumination). Exposure apparatus for the example 3 and the comparative example 2: Nikon NSR-S302 (NA

= 0.6, σ = 0.75).

Table 4

| | Sensitivity | Resolution limit | DOF | MEF | LER |
|---|---|---|---|---|---|
| Example 1 | 31 $mJ/cm^2$ | 110 nm trench pattern | 600 nm | 0.96 | 4.3 nm |
| Example 2 | 33 $mJ/cm^2$ | 110 nm trench pattern | 500 nm | 0.86 | 5.3 nm |
| Comparative example 1 | 29 $mJ/cm^2$ | 110 nm trench pattern | 400 nm | 0.66 | 6.5 nm |
| Example 3 | 25 $mJ/cm^2$ | 130 nm hole pattern | 500 nm | 1.65 | - |
| Comparative example 2 | 30$mJ/cm^2$ | 130 nm hole pattern | 400 nm | 1.97 | - |

<Sensitivity>

In the examples 1 and 2, and the comparative example 1, the sensitivity was determined for the formation of a 130 nm trench pattern. In the example 3 and the comparative example 2, the sensitivity was determined for the formation of a dense contact hole pattern (pitch 300 nm) with a hole diameter of 140 nm.

<Resolution Limit>

The resolution limit at the above sensitivity values. Evaluated using a trench pattern for the examples 1 and 2, and the comparative example 1. Evaluated using a dense contact hole pattern for the example 3 and the comparative example 2.

<DOF>

In the examples 1 and 2, and the comparative example 1, the depth of focus was measured for a 130 nm trench pattern. In the example 3 and the comparative example 2, the depth of focus was measured for a dense contact hole pattern (pitch 300 nm) with a hole diameter of 140 nm.

<MEF>

In the examples 1 and 2, and the comparative example 1, the value of the MEF (mask error factor) was determined from the above formula, using 120 nm and 200 nm line and space patterns. In the example 3 and the comparative example 2, the value of the MEF (mask error factor) was determined from the above formula, using dense contact hole patterns with hole diameters of 140 nm and 200 nm respectively.

<LER>

In the examples 1 and 2, and the comparative example 1, the width of a 120 nm line and space pattern was measured at 32 positions using a measuring SEM (S-9220, a product name, manufactured by Hitachi, Ltd.), and the LER value was determined as 3 times the standard deviation (3σ) calculated from these measurement results. Because the example 3 and the comparative example 2 were contact hole patterns, the level of LER could not be quantified, although a comparison of cross-sectional SEM photographs of the example 3 and the comparative example 2 revealed a reduced level of irregularities within the internal walls of the hole pattern of in the example 3.

## Claims

**1.** A resin for a resist, comprising structural units (a) derived from an (α-lower alkyl)acrylate ester as a principal component, wherein
said structural units (a) comprise structural units (a1) derived from an (α-lower alkyl)acrylate ester comprising an acid dissociable, dissolution inhibiting group, and structural units (a2-1) derived from an (α-lower alkyl)acrylate ester comprising a lactone-containing monocyclic group, and
said structural units (a1) comprise structural units (a1-1) derived from an (α-lower alkyl)acrylate ester and represented by a general formula (a1-1) shown below:

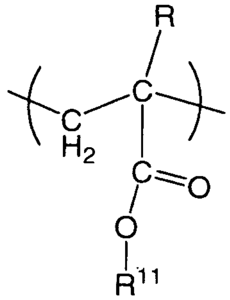

(a1-1)

[wherein, R represents a hydrogen atom or a lower alkyl group, and $R^{11}$ represents an acid dissociable, dissolution inhibiting group that comprises a monocyclic aliphatic hydrocarbon group and comprises no polycyclic aliphatic hydrocarbon groups].

**2.** A resin for a resist according to claim 1, wherein said structural units (a1-1) comprise structural units (a1-2) represented by a general formula (a1-2) shown below:

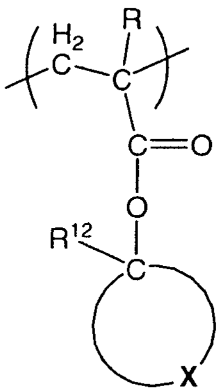

(a1-2)

[wherein, R represents a hydrogen atom or a lower alkyl group, $R^{12}$ represents a lower alkyl group, and X represents a group which, in combination with a carbon atom to which said group $R^{12}$ is bonded, forms a monocyclic aliphatic hydrocarbon group].

**3.** A resin for a resist according to claim 1 or 2, wherein R is either a straight-chain or branched group and is an alkyl group of 1 to 5 carbon atoms.

**4.** A resin for a resist, comprising structural units (a) derived from an (α-lower alkyl)acrylate ester as a principal component, wherein
said structural units (a) comprise structural units (a1) derived from an (α-lower alkyl)acrylate ester comprising an acid dissociable, dissolution inhibiting group, and structural units (a2) derived from an (α-lower alkyl)acrylate ester comprising a lactone-containing monocyclic or polycyclic group, and
said structural units (a1) comprise structural units (a1-1-1) derived from a methacrylate ester and represented by a general formula (a1-1-1) shown below:

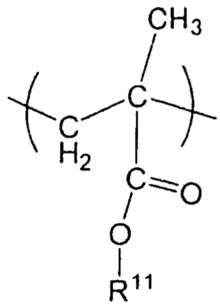

(a1-1-1)

[wherein, $R^{11}$ represents an acid dissociable, dissolution inhibiting group that comprises a monocyclic aliphatic hydrocarbon group and comprises no polycyclic aliphatic hydrocarbon groups].

**5.** A resin for a resist according to claim 4, wherein said structural units (a1-1-1) comprise structural units (a1-2-1) represented by a general formula (a1-2-1) shown below:

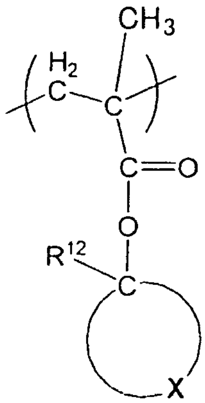

(a1-2-1)

[wherein, $R^{12}$ represents a lower alkyl group, and X represents a group which, in combination with a carbon atom to which said group $R^{12}$ is bonded, forms a monocyclic aliphatic hydrocarbon group].

**6.** A resin for a resist according to claim 2, 3 or 5, wherein $R^{12}$ is either a straight-chain or branched alkyl group containing from 1 to 8 carbon atoms.

**7.** A resin for a resist according to claim 6, wherein $R^{12}$ contains from 1 to 4 carbon atoms.

**8.** A resin for a resist according to any one of claims 1 to 7, wherein said structural units (a) also comprise structural units (a3) derived from an (α-lower alkyl)acrylate ester that comprises a polar group-containing aliphatic hydrocarbon group.

**9.** A resin for a resist according to any one of claims 1 to 8, wherein said structural units (a) also comprise other structural units (a4) derived from an (α-lower alkyl)acrylate ester that comprises a polycyclic aliphatic hydrocarbon group, which differ from said structural units (a2) and (a3).

**10.** A positive resist composition comprising: (A) a resist resin component that exhibits increased alkali solubility under action of acid, and (B) an acid generator component that generates acid on exposure, wherein said component (A) comprises a resin for a resist according to any one of claims 1 to 9.

**11.** A positive resist composition according to claim 10, further comprising a nitrogen-containing organic compound.

**12.** A method of forming a resist pattern, comprising the steps of: forming a positive resist film on top of a substrate

using a positive resist composition according to claim 10 or 11, conducting a selective exposure treatment of said positive resist film, and performing alkali developing to form a resist pattern.

## Patentansprüche

1. Harz für einen Photolack, umfassend strukturelle Einheiten (a), welche von einem (α-Niederalkyl)acrylatester als Hauptkomponente abgeleitet sind, wobei
die strukturellen Einheiten (a) strukturelle Einheiten (a1), welche von einem (α-Niederalkyl)acrylatester, welcher eine säuredissoziierbare auflösungsverhindernde Gruppe umfaßt, und strukturelle Einheiten (a2-1) umfassen, welche von einem (α-Niederalkyl)acrylatester, welcher eine Lactonenthaltende monozyklische Gruppe umfaßt, abgeleitet sind, und
die strukturellen Einheiten (a1) strukturellen Einheiten (a1-1) umfassen, welche von einem (α- Niederalkyl)acrylatester abgeleitet sind und durch eine unten gezeigte allgemeine Formel (a1-1) dargestellt sind:

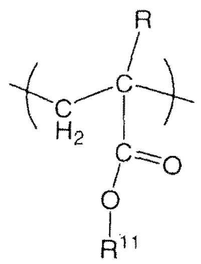

(a1-1)

[wobei R ein Wasserstoffatom oder eine Niederalkylgruppe darstellt und $R^{11}$ eine säuredissoziierbare auflösungsverhindernde Gruppe darstellt, die eine monozyklische aliphatische Kohlenwasserstoffgruppe umfaßt und die keine polyzyklischen aliphatischen Kohlenwasserstoffgruppen umfaßt].

2. Harz für einen Photolack nach Anspruch 1, wobei die strukturellen Einheiten (a1-1) strukturelle Einheiten (a1-2) umfassen, die durch eine unten gezeigte allgemeine Formel (a1-2) dargestellt sind:

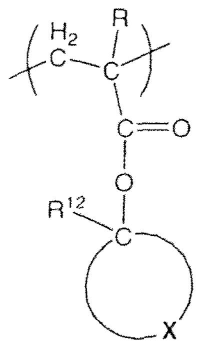

(a1-2)

[wobei R ein Wasserstoffatom oder eine Niederalkylgruppe darstellt, $R^{12}$ eine Niederalkylgruppe darstellt und X eine Gruppe darstellt, welche in Kombination mit einem Kohlenstoffatom, an welches die Gruppe $R^{12}$ gebunden ist, eine monozyklische aliphatische Kohlenwasserstoffgruppe bildet].

3. Harz für einen Photolack mach Anspruch 1 oder 2, wobei R entweder eine unverzweigte oder verzweigte Gruppe ist und eine Alkylgruppe mit 1 bis 5 Kohlenstoffatomen ist.

4. Harz für einen Photolack, umfassend strukturelle Einheiten (a), welche von einem (α- Niederalkyl)acrylatester als Hauptkomponente abgeleitet sind, wobei
die strukturellen Einheiten (a) strukturelle Einheiten (a1), welche von einem (α-Niederalkyl)acrylatester, welcher eine säuredissoziierbare auflösungsverhindernde Gruppe umfaßt, und strukturelle Einheiten (a2) umfassen, welche

von einem (α-Niederalkyl)acrylatester, welcher eine Lacton-enthaltende monozyklische oder polyzyklische Gruppe umfaßt, abgeleitet sind, und
die strukturellen Einheiten (a1) strukturellen Einheiten (a1-1-1) umfassen, welche von einem Methacrylatester abgeleitet sind und durch eine unten gezeigte allgemeine Formel (a1-1-1) dargestellt sind:

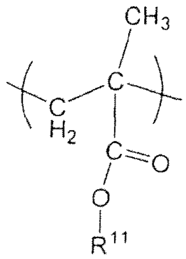

(a1-1-1)

[wobei $R^{11}$ eine säuredissoziierbare auflösungsverhindernde Gruppe darstellt, welche eine monozyklische aliphatische Kohlenwasserstoffgruppe umfaßt und keine polyzyklischen aliphatischen Kohlenwasserstoffgruppen umfaßt].

**5.** Harz für einen Photolack nach Anspruch 4, wobei die strukturellen Einheiten (a1-1-1) strukturelle Einheiten (a1-2-1) umfassen, die durch eine unten gezeigte allgemeine Formel (a1-2-1) dargestellt sind:

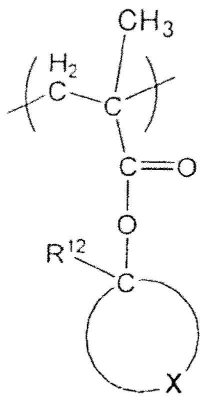

(a1-2-1)

[wobei $R^{12}$ eine Niederalkylgruppe darstellt und X eine Gruppe darstellt, welche in Kombination mit einem Kohlenstoffatom, an welches die Gruppe $R^{12}$ gebunden ist,
eine monozyklische aliphatische Kohlenwasserstoffgruppe bildet].

**6.** Harz für einen Photolack nach Anspruch 2, 3, oder 5, wobei $R^{12}$ entweder eine unverzweigte oder verzweigte Alkylgruppe ist, welche 1 bis 8 Kohlenstoffatome enthält.

**7.** Harz für einen Photolack nach Anspruch 6, wobei $R^{12}$ 1 bis 4 Kohlenstoffatome enthält.

**8.** Harz für einen Photolack nach einem der Ansprüche 1 bis 7, wobei die strukturellen Einheiten (a) auch strukturelle Einheiten (a3) umfassen, welche von einem (α- Niederalkyl)acrylatester, welcher eine eine polare Gruppe enthaltende aliphatische Kohlenwasserstoffgruppe umfaßt, abgeleitet sind.

**9.** Harz für einen Photolack nach einem der Ansprüche 1 bis 8, wobei die strukturellen Einheiten (a) auch andere strukturelle Einheiten (a4) umfassen, welche von einem (α- Niederalkyl)acrylatester, welcher eine polyzyklische aliphatische Kohlenwasserstoffgruppe umfaßt, abgeleitet sind, welche sich von den strukturellen Einheiten (a2) und

(a3) unterscheiden.

**10.** Positivphotolackzusammensetzung umfassend: (A) eine Photolackharzkomponente, die eine erhöhte Alkalilöslichkeit unter Säureeinwirkung aufweist, und (B) eine Säureerzeugerkomponente, die unter Nichteinwirkung Säure erzeugt, wobei
die Komponenten (A) ein Harz für einen Photolack nach einem der Ansprüche 1 bis 9 umfaßt.

**11.** Positivphotolackzusammensetzung nach Anspruch 10, ferner umfassend eine stickstoffhaltige organische Verbindung.

**12.** Verfahren zur Herstellung eines Photolackmusters, umfassend die Schritte: Bilden eines positiven Photolackfilms auf der Oberseite eines Trägermaterials mittels einer Positivphotolackzusammensetzung nach Anspruch 10 oder 11, Durchführen einer selektiven Lichtaussetzungsbehandlung des positiven Photolackfilms und Durchführen einer Alkalientwicklung, um ein Phtotolackmuster zu bilden.

## Revendications

**1.** Résine pour une réserve, comprenant des unités structurelles (a) dérivées d'un ester d'acrylate de (α-alkyle inférieur) en tant que constituant principal, dans laquelle
lesdites unités structurelles (a) comprennent des unités structurelles (a1) dérivées d'un ester d'acrylate de (α-alkyle inférieur) comprenant un groupe inhibant la dissolution, dissociable par un acide, et des unités structurelles (a2-1) dérivées d'un ester d'acrylate de (α-alkyle inférieur) comprenant un groupe monocyclique contenant une lactone, et lesdites unités structurelles (a1) comprennent des unités structurelles (a1-1) dérivées d'un ester d'acrylate de (α-alkyle inférieur) et représentées par la formule générale (a1-1) représentée ci-dessous :

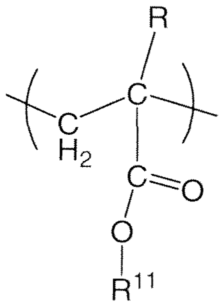

(a1-1)

[dans laquelle, R représente un atome d'hydrogène ou un groupe alkyle inférieur, et $R^{11}$ représente un groupe inhibant la dissolution, dissociable par un acide qui comprend un groupe hydrocarboné aliphatique monocyclique et ne comprend pas de groupe hydrocarboné aliphatique polycyclique].

**2.** Résine pour une réserve selon la revendication 1, dans laquelle lesdites unités structurelles (a1-1) comprennent des unités structurelles (a1-2) représentées par la formule générale (a1-2) représentée ci-dessous :

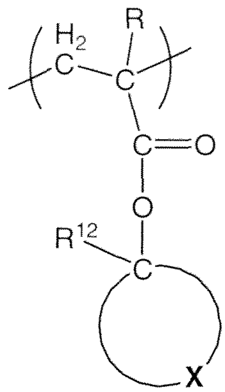

(a1-2)

[dans laquelle, R représente un atome d'hydrogène ou un groupe alkyle inférieur, $R^{12}$ représente un groupe alkyle inférieur, et X représente un groupe qui, en combinaison avec un atome de carbone auquel ledit groupe $R^{12}$ est lié, forme un groupe hydrocarboné aliphatique monocyclique].

3. Résine pour une réserve selon la revendication 1 ou 2, dans laquelle R est un groupe soit linéaire, soit ramifié et est un groupe alkyle de 1 à 5 atomes de carbone.

4. Résine pour une réserve, comprenant des unités structurelles (a) dérivées d'un ester d'acrylate de (α-alkyle inférieur) en tant que constituant principal, dans laquelle
lesdites unités structurelles (a) comprennent des unités structurelles (a1) dérivées d'un ester d'acrylate de (α-alkyle inférieur) comprenant un groupe inhibant la dissolution, dissociable par un acide, et des unités structurelles (a2) dérivées d'un ester d'acrylate de (α-alkyle inférieur) comprenant un groupe monocyclique ou polycyclique contenant une lactone, et
lesdites unités structurelles (a1) comprennent des unités structurelles (a1-1-1) dérivées d'un ester de méthacrylate et représentées par la formule générale (a1-1-1) représentée ci-dessous :

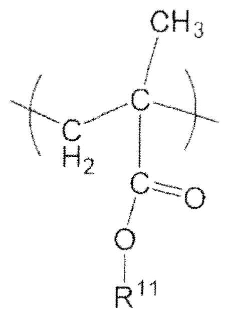

(a1-1-1)

[dans laquelle, $R^{11}$ représente un groupe inhibant la dissolution, dissociable par un acide qui comprend un groupe hydrocarboné aliphatique monocyclique et ne comprend pas de groupe hydrocarboné aliphatique polycyclique].

5. Résine pour une réserve selon la revendication 4, dans laquelle lesdites unités structurelles (a1-1-1) comprennent des unités structurelles (a1-2-1) représentées par la formule générale (a1-2-1) représentée ci-dessous :

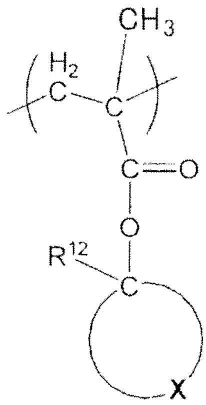

(a1-2-1)

[dans laquelle, $R^{12}$ représente un groupe alkyle inférieur, et X représente un groupe qui, en combinaison avec un atome de carbone auquel ledit groupe $R^{12}$ est lié, forme un groupe hydrocarboné aliphatique monocyclique].

**6.** Résine pour une réserve selon la revendication 2, 3 ou 5, dans laquelle $R^{12}$ est un groupe alkyle soit linéaire, soit ramifié contenant de 1 à 8 atomes de carbone.

**7.** Résine pour une réserve selon la revendication 6, dans laquelle $R^{12}$ contient de 1 à 4 atomes de carbone.

**8.** Résine pour une réserve selon l'une quelconque des revendications 1 à 7, dans laquelle lesdites unités structurelles (a) comprennent également des unités structurelles (a3) dérivées d'un ester d'acrylate de ($\alpha$-alkyle inférieur) qui comprend un groupe hydrocarboné aliphatique contenant un groupe polaire.

**9.** Résine pour une réserve selon l'une quelconque des revendications 1 à 8, dans laquelle lesdites unités structurelles (a) comprennent également d'autres unités structurelles (a4) dérivées d'un ester d'acrylate de ($\alpha$-alkyle inférieur) qui comprend un groupe hydrocarboné aliphatique polycyclique, lequel est différent desdites unités structurelles (a2) et (a3).

**10.** Composition de réserve positive comprenant : (A) un constituant de résine de réserve qui exhibe une solubilité plus élevée dans un alcali sous l'action d'un acide, et (B) un constituant générateur d'acide qui génère un acide lors d'une exposition, dans laquelle
ledit constituant (A) comprend une résine pour une réserve selon l'une quelconque des revendications 1 à 9.

**11.** Composition de réserve positive selon la revendication 10, comprenant de plus un composé organique contenant de l'azote.

**12.** Procédé de formation d'un motif de réserve, comprenant les étapes consistant : à former un film de réserve positive sur le haut d'un substrat en utilisant une composition de réserve positive selon la revendication 10 ou in, à réaliser un traitement d'exposition sélective dudit film de réserve positive, et à réaliser un développement alcalin pour former un motif de réserve.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2881969 B
- JP HEI5346668 B
- JP HEI7234511 B
- JP HEI973173 B
- JP HEI990637 B
- JP HEI10161313 B
- JP HEI10319595 B
- JP HEI1112326 B